# EUROPEAN PATENT SPECIFICATION

(11) **EP 4 214 150 B1**
(45) Date of publication and mention of the grant of the patent: **08.04.2026**
(21) Application number: 21782578.5
(22) Date of filing: 20.09.2021
(51) Int. Cl.: B81B 7/00, B81C 1/00

(54) **WAFER LEVEL PACKAGE FOR DEVICE**
VERPACKUNG AUF WAFEREBENE FÜR EINE VORRICHTUNG
BOÎTIER DE NIVEAU DE TRANCHE DESTINÉ À UN DISPOSITIF

(30) Priority: 21.09.2020 FI 20205914
(43) Date of publication of application: 26.07.2023
(73) Proprietor: Teknologian tutkimuskeskus VTT Oy, 02150 Espoo (FI)
(72) Inventor: LEE, Jae-Wung, 02044 VTT (FI)
(74) Representative: Laine IP Oy
(86) International application number: PCT/FI2021/050619
(87) International publication number: WO 2022/058659

(56) References cited:
- EP-A1- 2 346 083
- US-A1- 2009 014 871
- US-A1- 2010 084 752
- US-A1- 2012 299 128

## Description

### FIELD

The present invention relates to a wafer level package for a device, in particular to a wafer level package for microelectromechanical systems (MEMS).

### BACKGROUND

Microelectromechanical systems (MEMS) are miniaturized mechanical and electro-mechanical elements, such as devices and structures that are made using the techniques of microfabrication. MEMS are comprised of components between 1 and 100 micrometers in size and MEMS devices generally range in size from 20 micrometers to a millimeter.

MEMS devices are susceptible to electrical failures due to their small size, composition and extremely demanding manufacturing methods. Forming an electrical interconnection by, for example, TSV (through-silicon via) is a complex and expensive process.

Patent document US2010/0084752 Al discloses a wafer level MEMS device package where a cover substrate having stand-off mesas is solder bonded to a device substrate. Electrical connections to the outside involve metal leads placed on the surface of the mesas.

Thus, there is need for improved structures and manufacturing methods of a wafer packaging.

### SUMMARY OF THE INVENTION

The invention is defined by the features of the independent claims. Some specific embodiments are defined in the dependent claims.

According to a first aspect of the present invention, there is provided a wafer level package for a device, the package comprising: a first substrate and a second substrate, at least one insulating stand-off structure between the first substrate and the second substrate, a bonding layer on the at least one stand-off structure, and a first lateral electrical connection line on a surface of the first substrate and a second lateral electrical connection line on a surface the second substrate. Electrical connection is formed between the first lateral electrical connection line and the second lateral connection line via the bonding layer of the at least one stand-off structure. The bonding layer comprises a eutectic alloy.

According to a second aspect of the present invention, there is provided a method for forming a wafer level package for a device comprising: making a first lateral electrical connection line on a surface of a first substrate, making a second lateral electrical connection line on a surface of a second substrate, making at least one insulating stand-off structure over a portion of the first lateral electrical connection line, making a first bonding material layer on the surface of the at least one stand-off structure, and bonding the first bonding material layer with the second lateral electrical connection line to create a bonding layer on the stand-off structure to create an electrical connection between the first lateral electrical connection line and the second lateral connection line via the bonding layer of the at least one stand-off structure. Bonding the first bonding material layer with the second lateral electrical connection line is provided by eutectic bonding.

According to an embodiment, the package comprises at least one trench in the first substrate.

According to an embodiment, electrical connection is formed over the at least one trench via the second lateral connection line

According to an embodiment, electrical connection is formed over the at least one trench via the second bonding material layer.

According to an embodiment, the package comprises at least one sealing structure, which sealing structure comprises: a seal ring between the first substrate and the second substrate, a bonding layer on a surface of the second substrate, and plurality of micro-rings within the seal ring to confine metal melt of the bonding layer between micro-rings.

The present invention provides considerable advantages. The present invention enables a simple and cost effective way to provide an electrical interconnection between electrodes of devices and pads, especially when the electrodes and pads are separated by a deep trench and/or a deep trench with a cavity, or when electrodes of devices have a deep trench inside packaging and pads outside packaging. The structure is created automatically during fabricating a bonding structure. Thus, there is no need for additional lithography or etching processes, which would make the manufacturing process more complex and expensive.

The embodiments of the invention increase process window in the bonding of the substrates, especially in eutectic bonding of the substrates. The micro-rings also provide a precise gap due to a precise height of the micro-rings, which gap is free from temperature and pressure non-uniformities, such as voids.

The embodiments of the invention reduce slip misalignment between the bonding substrates due to local indentation and increased friction, hence improving bonding quality.

### BRIEF DESCRIPTION OF THE DRAWINGS

FIGURES 1 and 2A to 2C illustrate a wafer level package for a device in accordance with at least some embodiments of the present invention;
FIGURES 3A to 3F illustrate a manufacturing method of a first structure of a wafer level package for a device in accordance with at least some embodiments of the present invention;
FIGURES 4A to 4E illustrate a manufacturing method of a second structure of a wafer level package for a device in accordance with at least some embodiments of the present invention; and
FIGURES 5 and 6 illustrate a wafer level package for a device in accordance with at least some embodiments of the present invention.

### EMBODIMENTS

In the present context, the term "substrate" comprises a wafer, such as a MEMS device wafer and a cap wafer.

In the present context, the term "first structure" comprises a first substrate, such as a device wafer, and layers on the first substrate before bonding.

In the present context, the term "second structure" comprises a second substrate, such as s cap wafer, and layer(s) on the second substrate before bonding.

The object of at least some embodiments of the present invention is to provide a simple and cost effective electrical interconnection between electrodes of devices and pads, especially for a microelectromechanical systems (MEMS) device.

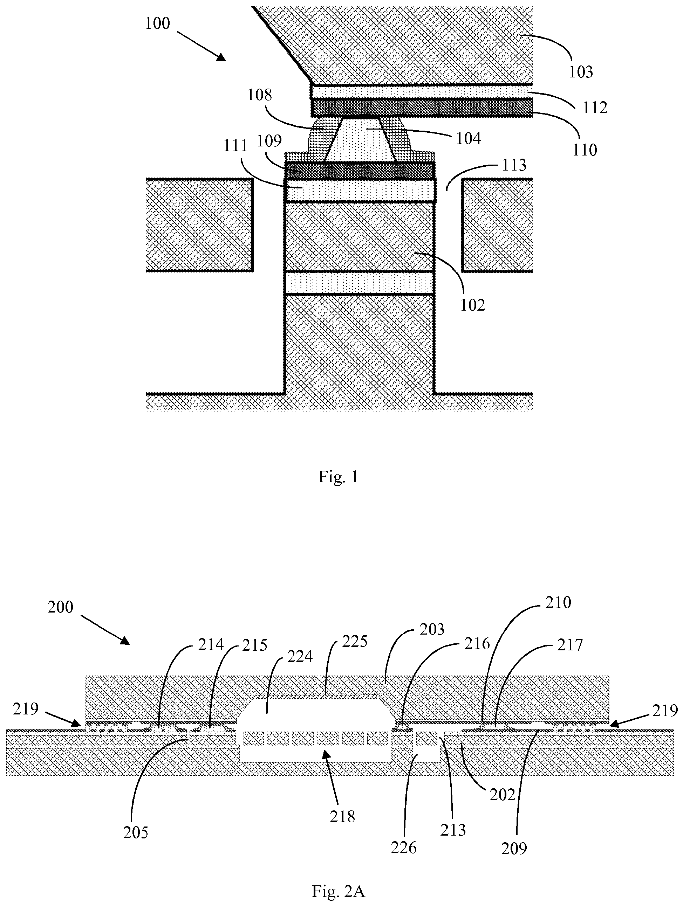

FIGURE 1 illustrates a portion of a wafer level package 100 according to an embodiment. The package 100 comprises a first substrate 102 and a second substrate 103, at least one insulating stand-off structure 104 between the first substrate 102 and the second substrate 103, a bonding layer 108 on the at least one stand-off structure 104, and a first lateral electrical connection line 109 on a surface of the first substrate 102 and a second lateral electrical connection line 110 on a surface the second substrate 103. Electrical connection is formed between the first lateral electrical connection line 109 and the second lateral connection line 110 via the bonding layer 108 of the at least one stand-off structure 104. This enables an electrical interconnection between electrodes of devices and pads, especially when the electrodes and pads are separated by a deep trench and/or a deep trench with a cavity, or when electrodes of devices have a deep trench inside packaging and pads outside packaging. The structure is created automatically during fabricating a bonding structure. Thus, there is no need for additional lithography or etching processes which would make the manufacturing process more complex and expensive.

The bonding layer 108 comprises a eutectic alloy. The eutectic alloy can comprise two or more metals. Suitable eutectic alloys include, for example, germanium-aluminum, gold-tin, gold-germanium, gold-silicon, gold-indium or copper-tin alloy.

According to an embodiment, each of the at least one insulating stand-off structure 104 has a height less than 10 µm, such as less than 5 µm, for example 1-2 µm.

According to an embodiment, the thickness of the first lateral electrical connection line 109 is 0.2-5 µm, such as 0.5-1 µm.

According to an embodiment, the thickness of the first lateral electrical connection line 109 is less than the height of the at least one insulating stand-off structure 104.

According to an embodiment, the thickness of the bonding layer 108 is less than 5 µm, such as 0.5-2 µm.

According to an embodiment, the first substrate 102 comprises a passivation layer 111 on the surface of the first substrate 102 and/or the second substrate 103 comprises a passivation layer 112 on the surface of the second substrate 103. The passivation layers can comprise silicon dioxide (SiO₂), aluminum oxide (Al₂O₃) or aluminum nitride (AlN), for instance. The passivation layers prevent short-circuiting the elements of the package or the packaged device by preventing electrical contact between the elements the substrates.

In an embodiment, the first substrate 102 and the second substrate 103 comprise silicon or ceramic. Silicon is very reliable substrate material as it suffers very little fatigue and can have long service lifetimes without breaking. In single crystal form, silicon has virtually no hysteresis and hence almost no energy dissipation. Suitable ceramic substrates are, for example, silicon nitride, aluminium nitride, titanium nitride or silicon carbide. Aluminum nitride in the wurtzite structure shows pyroelectric and piezoelectric properties, which enables to produce sensors for example, with sensitivity to normal and shear forces. Titanium nitride exhibits a high electrical conductivity and large elastic modulus.

According to an embodiment, the first lateral electrical connection line 109 and the second electrical connection line 110 comprise metal, such as molybdenum, aluminum or copper. These metals enable good and reliable electrical connection in the lateral electrical connection line between the device inside the package and the electrical circuit outside the package.

According to an embodiment, the insulating stand-off structure 104 comprises dielectric material, such as ceramic material. The stand-off structure can comprise for example, silicon dioxide (SiO₂), aluminum nitride (AlN), aluminium oxide (Al₂O₃), silicon nitride (Si₃N₄) or silicon carbide (SiC). These substances provide a good wetting surface for the bonding layer 108 and a good electric insulation.

In an embodiment, the package 100, 200 comprises at least one trench 113, 205, 213 in the first substrate 102, 202. Then, electrical connection is formed between the first lateral electrical connection line 109, 209 and the second lateral connection line 110, 210 via the bonding layer 108 of the at least one stand-off structure 104, 214, 215, 216, 217 and over at least one trench 113, 205, 213 via the second lateral connection line. This enables a simple and cost effective structure to provide electrical interconnection for devices separated by trenches.

According to an embodiment, the wafer level package 200 comprises a cavity 224 in the second substrate 203.

According to an embodiment, the package 200 comprises a getter 225 on a surface of the cavity 224. The getter 225 can be used to create and maintain vacuum. The getter can be a thin film getter. The getter absorbs some or all of the gases anticipated to outgas into the cavity, such as water vapour, oxygen, carbon monoxide, carbon dioxide, nitrogen, hydrogen and/or other gases. The getter comprises metals that easily absorb gas. For example, the getter can comprise at least one of the following: titanium, aluminum, zirconium, boron, cobalt, calcium, strontium or thorium.

In an embodiment, the wafer level package 200 comprises at least one sealing structure 219. The sealing structure 219 can comprise a seal ring 221 between the first substrate 202 and the second substrate 203, a bonding layer 222 on a surface of the second substrate and plurality of micro-rings 223 within the seal ring to confine metal melt of the bonding layer between micro-rings.

More information about seal rings and other associated structures is provided in Patent Application in Finland No. 20205075, which is incorporated herein by reference.

The micro-rings of sealing structure 219 increase process window in the bonding of the substrates, especially in eutectic bonding of the substrates. The micro-rings also provide a precise gap due to a precise height of the micro-rings, which gap is free from temperature and pressure non-uniformities, such as voids. The sealing structure reduces slip misalignment between the bonding substrates due to local indentation and increased friction, hence improving bonding quality.

The seal ring 221 can comprise dielectric material or ceramic material, for example, silicon dioxide (SiO₂), aluminum nitride (AlN), aluminium oxide (Al₂O₃), silicon nitride (Si₃N₄) or silicon carbide (SiC).

The bonding layer 222 can comprise a eutectic alloy. The eutectic alloy can comprise two or more metals. Suitable eutectic alloys include, for example, germanium-aluminum, gold-tin, gold-germanium, gold-silicon, gold-indium or copper-tin alloy.

The structure of wafer package for a device will now be discussed in more detail by means of example embodiments.

FIGURES 2A to 2C illustrate that the package 200 comprises four stand-off structures 214, 215, 216, 217 between the first substrate 202 and the second substrate 203. The package comprises a bonding layer 208 on the stand-off structures 214, 215, 216, 217. A first lateral electrical connection line 209 is on a surface of the first substrate 202 and a second lateral electrical connection line 210 is on a surface the second substrate 203.

FIGURES 2A to 2C illustrate that the package 200 comprises at least one trench 205, 213 in the first substrate 202. The package can comprise a trench 205 between insulating stand-off structures 214, 215 and a trench 213 between insulating stand-off structures 216, 217. Then, electrical connection is formed between the first lateral electrical connection line 209 and the second lateral connection line 210 via the bonding layers 208 of the stand-off structures 214, 215 and the second lateral electrical connection line 210 over the trench 205 and via the bonding layers 208 of the stand-off structures 216, 217 together with the second lateral electrical connection line 210 over the trench 213.

FIGURES 2A to 2C illustrate that the package 200 comprises a trench 213 with a cavity 226.

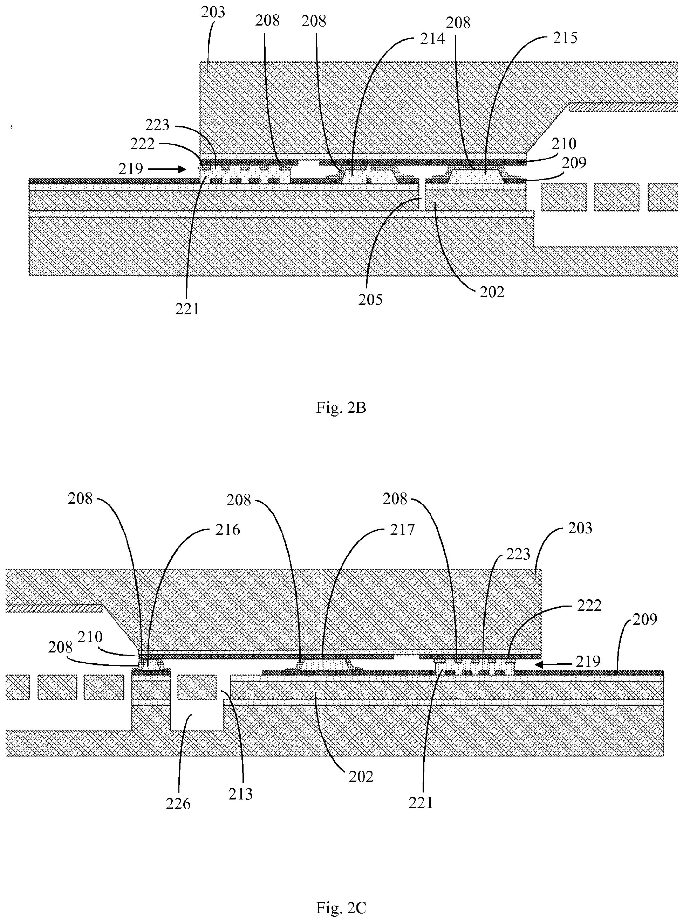

FIGURE 2B illustrates that electric signal can pass from the first electrical lateral connection line 209 to the second lateral electrical connection line 210 through the bonding layer 208 of the stand-off structure 215 and through the second lateral electrical connection line 210 over the trench 205 between the stand-off structures 214, 215. Respectively, electric signal can pass from the second lateral electrical connection line 210 to the first lateral electrical connection line 209 through the bonding layer 208 of the stand-off structure 214.

FIGURE 2C illustrates that electric signal can pass from the first lateral electrical connection line to the second lateral electrical connection line through the bonding layer of the stand-off structure 216 and through the second lateral electrical connection line 210 over the trench 213 between the stand-off structures 216, 217. Respectively, electric signal can pass from the second lateral electrical connection line 210 to the first lateral electrical connection line 209 through the bonding layer 208 of the stand-off structure 217.

Furthermore, FIGURE 2A illustrates that the wafer level package 200 comprises a cavity 224 in the second substrate 203. In addition, the package 200 comprises a getter 225 on a surface of the cavity 224.

FIGURES 2A to 2C illustrate that the wafer level package 200 comprise a sealing structure 219. The sealing structure 219 may surround the cavity 224.

According to an embodiment, there is provided a method for forming a wafer level package 100, 200 for a device, the method comprising: making a first lateral electrical connection line 109, 209 on a surface of a first substrate 102, 202, making a second lateral electrical connection line 110, 210 on a surface of a second substrate 103, 203, making at least one insulating stand-off structure 104, 214, 215, 216, 217 over a portion of the first lateral electrical connection line 109, 209, making a first bonding material layer 106, 206 on the surface of the at least one stand-off structure 104, 214, 215, 216, 217, and bonding the first bonding material layer 106, 206 with the second lateral electrical connection line 110, 210 to create a bonding layer 108, 208 on the stand-off structure 104, 214, 215, 216, 217 to create an electrical connection between the first lateral electrical connection line 109, 209 and the second lateral connection line 110, 210 via the bonding layer 108, 208 of the at least one stand-off structure 104, 214, 215, 216, 217. This enables a simple and cost effective way to provide electrical interconnection for devices.

Bonding the first bonding material layer 106, 206 with the second lateral electrical connection line 110, 210 is provided by eutectic bonding. First, temperature can be raised to a value lower than the eutectic temperature of the eutectic alloy. Then, temperature can be maintained constant for short time to reach uniform heating of both first substrate and second substrate. After that, temperature can be increased to a temperature exceeding the eutectic point. Finally, the structure can cool down to a temperature below the eutectic temperature.

Eutectic bonding does not require use of high contact force during the bonding. Eutectic bonding is less sensitive to surface flatness irregularities, scratches, as well as to particles compared to the direct wafer bonding methods, because the eutectic bonding process goes through a liquid phase.

According to an embodiment, the second lateral electrical connection line 110, 210 comprises a second bonding material layer 107, 207 on a surface of the second lateral electrical connection line 110, 210. Thus, the first bonding material layer 106, 206 can be bond with the second bonding material layer 107, 207 to create bonding layer 108, 208.

According to an embodiment, the method comprises making a passivation layer 111, 211 on the surface of the first substrate 102, 202 and/or making a passivation layer 112, 212 on the surface of the second substrate 103, 203. The passivation layer 111, 112 can be grown by thermal oxidation in which a layer is exposed to oxygen and/or steam to grow a thin surface layer on the layer.

According to an embodiment, the method comprises making at least one trench 113, 205, 213 in the first substrate 102, 202. The method can comprise making a trench 205 between insulating stand-off structures 214, 215 and a trench 213 between insulating stand-off structures 216, 217. The trench can be formed by for example, silicon wet or dry etching.

The method can comprise forming of a cavity 224 in the second substrate 203. The cavity can be formed by for example, silicon wet or dry etching.

Furthermore, the method can comprise forming a getter 225 on the cavity 224 in the second substrate 203. The getter 225 can be formed by getter deposition process. The getter can be deposited for example, by using sputtering, resistive evaporation, e-beam evaporation or other suitable deposition technique.

In an embodiment, the method comprises making at least one sealing structure 219 over a portion of the first lateral electrical connection line 209. First, a seal ring 221 of the sealing structure 219 is formed over a portion of the first lateral electrical connection line 209. Then, a first bonding material layer 206 is formed on a surface of the seal ring 221. After that, a second bonding material layer 207 is formed on a surface of a second substrate 203. Finally, the first bonding material layer is bond with the second bonding material layer to create bonding layer 208.

Layers of at least one sealing structure 219 can be formed simultaneously with layers of at least one insulating stand-off structure 104, 214-217. For example, the seal ring 221 of the sealing structure 219 can be formed while the insulating stand-off structure 104, 214-217 is formed. Accordingly, the first bonding material layers 206 and the second bonding material layers 207 of the sealing structure and insulating stand-off structure can be formed simultaneously.

The method for forming the wafer package for a device will now be discussed in more detail by means of example embodiments.

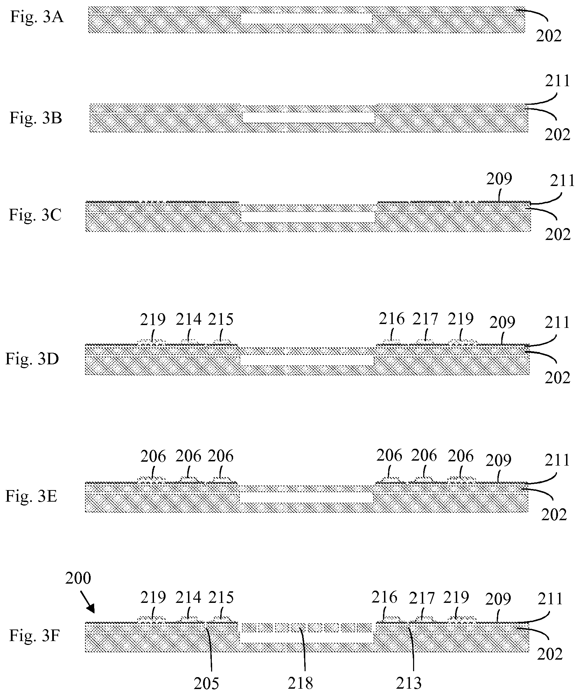

FIGURES 3A to 3F illustrate a manufacturing method of a first structure according to some embodiments. First, a first substrate 202 for preparing a MEMS structure is obtained. The structure comprises two layers of silicon bonded together and enclosing a cavity inside, as is illustrated in FIGURE 3A. Then, a passivation layer 211 is provided on the first substrate 202 (FIGURE 3B). A first lateral electrical connection line 209 is deposited on the passivation layer 211 (FIGURE 3C). After that, at least one insulating stand-off structure 214, 215, 216, 217 is deposited on the first lateral electrical connection line 209. Moreover, also at least one sealing structure 219 can be deposited on the first lateral electrical connection line 209 (FIGURE 3D). Then, a first bonding material layer 206 is deposited on a surface of the at least one stand-off structure 214, 215, 216, 217 and/or at least one sealing structure 219 as illustrated in FIGURE 3E. Finally, trenches 205, 213 and a MEMS device 218 are formed in the first substrate 202, for example, by silicon wet or dry etching.

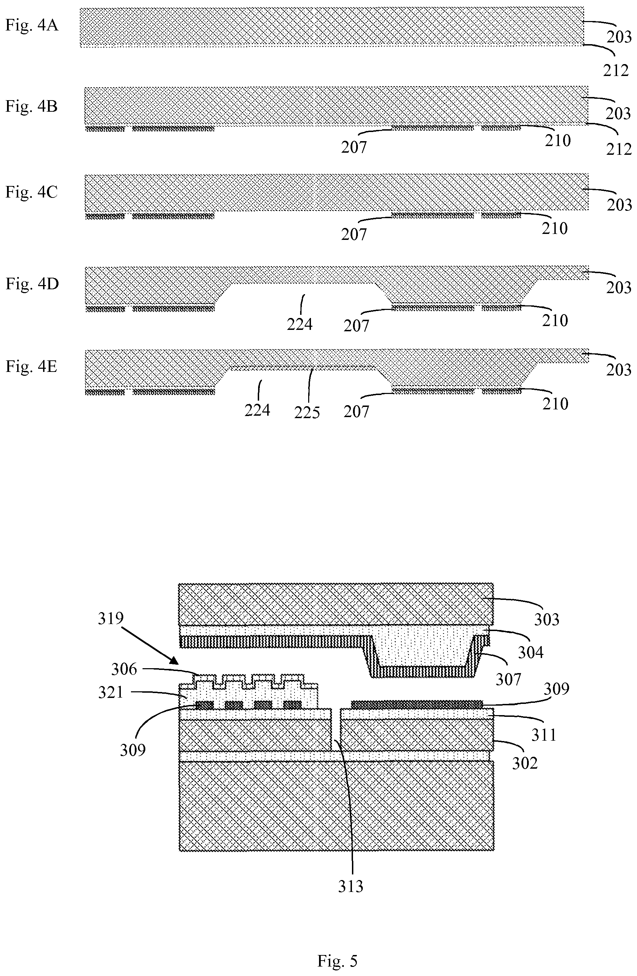

FIGURES 4A to 4E illustrate a manufacturing method of a second structure according to some embodiments. First, a passivation layer 212 is provided on a second substrate 203 (FIGURE 4A). Then, a second lateral electrical connection line 210 and a second bonding material layer 207 is deposited on the passivation layer 212 (FIGURE 4B). As illustrated in FIGURE 4C, the passivation layer 212 can be removed partially, for example, by plasma cleaning, wet chemical etching or dry chemical etching. After that, a cavity 224 can be formed in the second substrate 203, for example, by silicon wet or dry etching (FIGURE 4D). Finally and optionally, a getter 225 can be deposited on a surface of the cavity 224 as illustrated in FIGURE 4E.

A deposition of layers of the wafer level package 100, 200, such as a first bonding material layer 106, 206 and a second bonding material layer 107, 207, can be conducted by a deposition process. The deposition process can comprise for example, physical vapor deposition (PVD) or chemical vapor deposition (CVD).

FIGURE 5 illustrates an alternative embodiment for forming a wafer level package. A first substrate 302 comprises a passivation layer 311 on a surface of the first substrate. In addition, the first substrate 302 comprises a sealing structure 319 and a first lateral connection line 309 on a surface of the first substrate. The sealing structure 319 comprises a seal ring 321 and a first bonding material layer 306 on a surface of the seal ring. A second substrate 303 comprises a stand-off structure 304. The stand-off structure 304 comprises a second bonding material layer 307 on a surface of the stand-off structure. A trench 313 is formed in the first substrate between the sealing structure and the stand-off structure 304.

The wafer level package is formed by bonding the first bonding material layer 306 on the sealing ring 321 with the second bonding material layer 307 to form a bonding layer. Then, electrical connection is formed over the at least one trench 313 via the second bonding material layer 307.

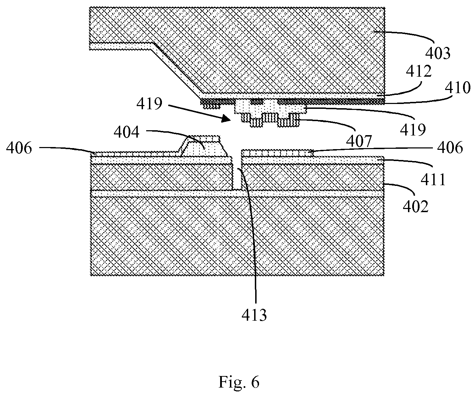

FIGURE 6 illustrates an alternative embodiment for a wafer level package. A first substrate 402 comprises a stand-off structure 404. A first bonding material layer 406 is partially on a surface of the stand-off structure 404 and the first substrate 402. A second substrate 403 comprises a second lateral electrical connection line 410 and a sealing structure 419. The sealing structure 419 comprises a seal ring 421. A second bonding material layer 407 is on a surface of the seal ring and partially on a surface of the second lateral electrical connection line 410. The first substrate can further comprise a passivation layer 411 on a surface of the first substrate and the second substrate can further comprise a passivation layer 412 on a surface of the second substrate. A trench 413 is in the first substrate between the stand-off structure 404 and the sealing structure 419.

The wafer level package is formed by bonding the first bonding material layer 406 with the second bonding material layer 407. Then, electrical connection is formed over the trench via the second lateral electrical connection line 410.

According to some embodiments, the sealing structure is for a MEMS device. However, the sealing structure can be used in other devices, such as automotive devices, e.g. lidar components and tire pressure sensors, RF components, e.g. switches, filters, inductors and antennas, passive photonic devices, e.g. silicon wave guide and modulator, microspectrometer components and plasmonic devices.

It is to be understood that the embodiments of the invention disclosed are not limited to the particular structures, process steps, or materials disclosed herein, but are extended to equivalents thereof as would be recognized by those ordinarily skilled in the relevant arts. It should also be understood that terminology employed herein is used for the purpose of describing particular embodiments only and is not intended to be limiting.

Reference throughout this specification to "one embodiment" or "an embodiment" means that a particular feature, structure, or characteristic described in connection with the embodiment is included in at least one embodiment of the present invention. Thus, appearances of the phrases "in one embodiment" or "in an embodiment" in various places throughout this specification are not necessarily all referring to the same embodiment.

As used herein, a plurality of items, structural elements, compositional elements, and/or materials may be presented in a common list for convenience. However, these lists should be construed as though each member of the list is individually identified as a separate and unique member. Thus, no individual member of such list should be construed as a de facto equivalent of any other member of the same list solely based on their presentation in a common group without indications to the contrary. In addition, various embodiments and example of the present invention may be referred to herein along with alternatives for the various components thereof. It is understood that such embodiments, examples, and alternatives are not to be construed as de facto equivalents of one another, but are to be considered as separate and autonomous representations of the present invention.

Furthermore, the described features, structures, or characteristics may be combined in any suitable manner in one or more embodiments. In the following description, numerous specific details are provided, such as examples of lengths, widths, shapes, etc., to provide a thorough understanding of embodiments of the invention. One skilled in the relevant art will recognize, however, that the invention can be practiced without one or more of the specific details, or with other methods, components, materials, etc. In other instances, well-known structures, materials, or operations are not shown or described in detail to avoid obscuring aspects of the invention.

### REFERENCE SIGNS LIST

- 100, 200: wafer level package
- 102, 202, 302, 402: first substrate
- 103, 203, 303, 403: second substrate
- 104, 304, 404: stand-off structure
- 106, 206, 306, 406: first bonding material layer
- 107, 207, 307, 407: second bonding material layer
- 108, 208: bonding layer
- 109, 209, 309: first lateral electrical connection line
- 110, 210, 410: second lateral electrical connection line
- 111, 112, 211, 212, 311, 411, 412: passivation layer
- 113, 205, 213, 313, 413: trench
- 214-217: stand-off structure
- 218: MEMS device
- 219, 319, 419: sealing structure
- 221, 321, 421: seal ring
- 222: bonding layer
- 223: micro-ring
- 224, 226: cavity
- 225: getter

## Claims

1. A wafer level package (100) for a device, the package (100) comprising:
- a first substrate (102) and a second substrate (103),
- at least one insulating stand-off structure (104) between the first substrate (102) and the second substrate (103),
- a bonding layer (108) on the at least one stand-off structure (104),
- a first lateral electrical connection line (109) on a surface of the first substrate (102) and a second lateral electrical connection line (110) on a surface the second substrate (103),
wherein electrical connection is formed between the first lateral electrical connection line (109) and the second lateral connection line (110) via the bonding layer (108) of the at least one stand-off structure (104), and
**characterised in that** :
the bonding layer (108) comprises a eutectic alloy.

2. The wafer level package (100) of claim 1, wherein each of the at least one insulating stand-off structure (104) has a height less than 10 µm, such as less than 5 µm, for example 1-2 µm.

3. The wafer level package (100) of any one of the preceding claims, wherein the thickness of the first lateral electrical connection line (109) is 0.2-5 µm, such as 0.5-1 µm.

4. The wafer level package (100) of any one of the preceding claims, wherein the thickness of the first lateral electrical connection line (109) is less than the height of the at least one insulating stand-off structure (104).

5. The wafer level package (100) of any one of the preceding claims, wherein the thickness of the bonding layer (108) is less than 5 µm, such as 0.5-2 µm.

6. The wafer level package (100, 200) of any one of the preceding claims, wherein the package (100, 200) comprises at least one trench (113, 205, 213) in the first substrate (102, 202).

7. The wafer level package (100, 200) of claim 6, wherein electrical connection is formed over the at least one trench (113, 205, 213) via the second lateral connection line (110, 210).

8. The wafer level package (100, 200) of claim 6, wherein electrical connection is formed over the at least one trench (313) via a second bonding material layer (307).

9. The wafer level package (200) of any one of the preceding claims, wherein the package (200) comprises at least one sealing structure (219), which sealing structure (219) comprises:
- a seal ring (221) between the first substrate (202) and the second substrate (203),
- a bonding layer (222) on a surface of the second substrate, and
- plurality of micro-rings (223) within the seal ring to confine metal melt of the bonding layer between micro-rings.

10. The wafer level package (100) of any one of the preceding claims, wherein the package (100) is for a MEMS device.

11. The wafer level package (100) of any one of the preceding claims, wherein the first lateral electrical connection line (109) and the second electrical connection line (110) comprise metal.

12. A method for forming a wafer level package (200) for a device comprising:
- making a first lateral electrical connection line (209) on a surface of a first substrate (202),
- making a second lateral electrical connection line (210) on a surface of a second substrate (203),
- making at least one insulating stand-off structure (214) over a portion of the first lateral electrical connection line (209),
- making a first bonding material layer (206) on the surface of the at least one stand-off structure (214), and
- bonding the first bonding material layer (206) with the second lateral electrical connection line (210) to create a bonding layer (208) on the stand-off structure (214) to create an electrical connection between the first lateral electrical connection line (209) and the second lateral connection line (210) via the bonding layer (208) of the at least one stand-off structure (214), and
wherein bonding the first bonding material layer (206) with the second lateral electrical connection line (210) is provided by eutectic bonding.

13. The method of claim 12, wherein each of the at least one insulating stand-off structure (104) has a height less than 10 µm, such as less than 5 µm, for example 1-2 µm, and the thickness of the first lateral electrical connection line (109) is 0.2-5 µm, such as 0.5-1 µm.

14. The method of any one of the preceding claims 12 to 13, wherein the method comprises making a second bonding material layer (207) on a surface of the second lateral electrical connection line (210) and making at least one sealing structure (219) over a portion of the first lateral electrical connection line (209).

15. The method of any one of the preceding claims 12 to 14, wherein the method comprises making at least one trench (205, 213) in the first substrate (202).

## Patentansprüche

1. Package auf Waferebene (100) für eine Vorrichtung, wobei das Package (100) umfasst:
- ein erstes Substrat (102) und ein zweites Substrat (103),
- mindestens eine isolierende Abstandsstruktur (104) zwischen dem ersten Substrat (102) und dem zweiten Substrat (103),
- eine Bindungsschicht (108) auf der mindestens einen Abstandsstruktur (104),
- eine erste seitliche elektrische Verbindungsleitung (109) auf einer Oberfläche des ersten Substrats (102) und eine zweite seitliche elektrische Verbindungsleitung (110) auf einer Oberfläche des zweiten Substrats (103),
wobei zwischen der ersten seitlichen elektrischen Verbindungsleitung (109) und der zweiten seitlichen Verbindungsleitung (110) über die Bindungsschicht (108) der mindestens einen Abstandsstruktur (104) eine elektrische Verbindung gebildet wird, und
**dadurch gekennzeichnet, dass**:
die Bindungsschicht (108) eine eutektische Legierung umfasst.

2. Package auf Waferebene (100) nach Anspruch 1, wobei jede der mindestens einen isolierenden Abstandsstruktur (104) eine Höhe von weniger als 10 µm, beispielsweise weniger als 5 µm, etwa 1-2 µm aufweist.

3. Package auf Waferebene (100) nach einem der vorstehenden Ansprüche, wobei die Dicke der ersten seitlichen elektrischen Verbindungsleitung (109) 0,2-5 µm, beispielsweise 0,5-1 µm, beträgt.

4. Package auf Waferebene (100) nach einem der vorstehenden Ansprüche, wobei die Dicke der ersten seitlichen elektrischen Verbindungsleitung (109) geringer ist als die Höhe der mindestens einen isolierenden Abstandsstruktur (104).

5. Package auf Waferebene (100) nach einem der vorstehenden Ansprüche, wobei die Dicke der Bindungsschicht (108) weniger als 5 µm, beispielsweise 0,5-2 µm beträgt.

6. Package auf Waferebene (100, 200) nach einem der vorstehenden Ansprüche, wobei das Package (100, 200) mindestens einen Graben (113, 205, 213) in dem ersten Substrat (102, 202) umfasst.

7. Package auf Waferebene (100, 200) nach Anspruch 6, wobei die elektrische Verbindung über dem mindestens einen Graben (113, 205, 213) mittels der zweiten seitlichen Verbindungsleitung (110, 210) gebildet wird.

8. Package auf Waferebene (100, 200) nach Anspruch 6, wobei die elektrische Verbindung über den mindestens einen Graben (313) mittels einer zweiten Verbindungsschicht (307) gebildet wird.

9. Package auf Waferebene (200) nach einem der vorstehenden Ansprüche, wobei das Package (200) mindestens eine Dichtungsstruktur (219) umfasst, wobei die Dichtungsstruktur (219) Folgendes umfasst:
- einen Dichtungsring (221) zwischen dem ersten Substrat (202) und dem zweiten Substrat (203),
- eine Bindungsschicht (222) auf einer Oberfläche des zweiten Substrats, und
- eine Vielzahl von Mikroringen (223) innerhalb des Dichtungsrings, um Metallschmelze der Bindungsschicht zwischen den Mikroringen einzuschließen.

10. Package auf Waferebene (100) nach einem der vorstehenden Ansprüche, wobei das Package (100) für eine MEMS-Vorrichtung bestimmt ist.

11. Package auf Waferebene (100) nach einem der vorstehenden Ansprüche, wobei die erste seitliche elektrische Verbindungsleitung (109) und die zweite elektrische Verbindungsleitung (110) Metall umfassen.

12. Verfahren zum Bilden eines Packages auf Waferebene (200) für eine Vorrichtung, umfassend:
- Herstellen einer ersten seitlichen elektrischen Verbindungsleitung (209) auf einer Oberfläche eines ersten Substrats (202),
- Herstellen einer zweiten seitlichen elektrischen Verbindungsleitung (210) auf einer Oberfläche eines zweiten Substrats (203),
- Herstellen mindestens einer isolierende Abstandsstruktur (214) über einem Teil der ersten seitlichen elektrischen Verbindungsleitung (209),
- Herstellen einer ersten Bindungsmaterialschicht (206) auf die Oberfläche der mindestens einen Abstandsstruktur (214) und
- Binden der ersten Bindungsmaterialschicht (206) mit der zweiten seitlichen elektrischen Verbindungsleitung (210) zur Erzeugen einer Bindungsschicht (208) auf der Abstandsstruktur (214), um eine elektrische Verbindung zwischen der ersten seitlichen elektrischen Verbindungsleitung (209) und der zweiten seitlichen Verbindungsleitung (210) über die Bindungsschicht (208) der mindestens einen Abstandsstruktur (214) herzustellen, und
wobei Binden der ersten Bindungsmaterialschicht (206) mit der zweiten seitlichen elektrischen Verbindungsleitung (210) durch eutektische Bindung erfolgt.

13. Verfahren nach Anspruch 12, wobei jede der mindestens einen isolierenden Abstandsstruktur (104) eine Höhe von weniger als 10 µm, beispielsweise weniger als 5 µm, beispielsweise 1-2 µm, aufweist und die Dicke der ersten seitlichen elektrischen Verbindungsleitung (109) 0,2-5 µm, beispielsweise 0,5-1 µm, beträgt.

14. Verfahren nach einem der vorstehenden Ansprüche 12 bis 13, wobei das Verfahren Herstellen einer zweiten Bindungsmaterialschicht (207) auf einer Oberfläche der zweiten seitlichen elektrischen Verbindungsleitung (210) und Herstellen mindestens einer Dichtungsstruktur (219) über einem Abschnitt der ersten seitlichen elektrischen Verbindungsleitung (209) umfasst.

15. Verfahren nach einem der vorstehenden Ansprüche 12 bis 14, wobei das Verfahren Herstellen mindestens eines Grabens (205, 213) in dem ersten Substrat (202) umfasst.

## Revendications

1. Boîtier sur tranche (100) pour un dispositif, le boîtier (100) comprenant :
- un premier substrat (102) et un second substrat (103),
- au moins une structure d'écartement isolante (104) entre le premier substrat (102) et le second substrat (103),
- une couche de liaison (108) sur au moins une structure d'écartement (104),
- une première ligne de connexion électrique latérale (109) sur une surface du premier substrat (102) et une seconde ligne de connexion électrique latérale (110) sur une surface du second substrat (103),
dans lequel une connexion électrique est formée entre la première ligne de connexion électrique latérale (109) et la seconde ligne de connexion latérale (110) via la couche de liaison (108) de la ou des structures d'écartement (104), et
**caractérisé en ce que** :
la couche de liaison (108) comprend un alliage eutectique.

2. Boîtier sur tranche (100) selon la revendication 1, dans lequel chacune de la ou des structures d'écartement isolantes (104) présente une hauteur inférieure à 10 µm, telle qu'inférieure à 5 µm, par exemple de 1 à 2 µm.

3. Boîtier sur tranche (100) selon l'une quelconque des revendications précédentes, dans lequel l'épaisseur de la première ligne de connexion électrique latérale (109) est de 0,2 à 5 µm, telle que de 0,5 à 1 µm.

4. Boîtier sur tranche (100) selon l'une quelconque des revendications précédentes, dans lequel l'épaisseur de la première ligne de connexion électrique latérale (109) est inférieure à la hauteur de la ou des structures d'écartement isolantes (104).

5. Boîtier sur tranche (100) selon l'une quelconque des revendications précédentes, dans lequel l'épaisseur de la couche de liaison (108) est inférieure à 5 µm, telle que de 0,5 à 2 µm.

6. Boîtier sur tranche (100, 200) selon l'une quelconque des revendications précédentes, dans lequel le boîtier (100, 200) comprend au moins une tranchée (113, 205, 213) dans le premier substrat (102, 202).

7. Boîtier sur tranche (100, 200) selon la revendication 6, dans lequel la connexion électrique est formée sur la ou les tranchées (113, 205, 213) via la seconde ligne de connexion latérale (110, 210).

8. Boîtier sur tranche (100, 200) selon la revendication 6, dans lequel la connexion électrique est formée sur la ou les tranchées (313) via une seconde couche de matériau de liaison (307).

9. Boîtier sur tranche (200) selon l'une quelconque des revendications précédentes, dans lequel le boîtier (200) comprend au moins une structure d'étanchéité (219), laquelle structure d'étanchéité (219) comprend :
- un anneau d'étanchéité (221) entre le premier substrat (202) et le second substrat (203),
- une couche de liaison (222) sur une surface du second substrat, et
- une pluralité de micro-anneaux (223) à l'intérieur de l'anneau d'étanchéité pour confiner le métal fondu de la couche de liaison entre les micro-anneaux.

10. Boîtier sur tranche (100) selon l'une quelconque des revendications précédentes, dans lequel le boîtier (100) est destiné à un dispositif MEMS.

11. Boîtier sur tranche (100) selon l'une quelconque des revendications précédentes, dans lequel la première ligne de connexion électrique latérale (109) et la seconde ligne de connexion électrique (110) comprennent du métal.

12. Procédé de formation d'un boîtier sur tranche (200) pour un dispositif, comprenant :
- la réalisation d'une première ligne de connexion électrique latérale (209) sur une surface d'un premier substrat (202),
- la réalisation d'une seconde ligne de connexion électrique latérale (210) sur une surface d'un second substrat (203),
- la réalisation d'au moins une structure d'écartement isolante (214) sur une partie de la première ligne de raccordement électrique latérale (209),
- la réalisation d'une première couche de matériau de liaison (206) sur la surface de la ou des structures d'écartement (214), et
- la liaison de la première couche de matériau de liaison (206) à la seconde ligne de connexion électrique latérale (210) pour créer une couche de liaison (208) sur la structure d'écartement (214) afin de créer une connexion électrique entre la première ligne de connexion électrique latérale (209) et la seconde ligne de connexion latérale (210) via la couche de liaison (208) de la ou des structures d'écartement (214), et
dans lequel la liaison de la première couche de matériau de liaison (206) à la seconde ligne de connexion électrique latérale (210) est assurée par liaison eutectique.

13. Procédé selon la revendication 12, dans lequel chacune de la ou des structures d'écartement isolantes (104) présente une hauteur inférieure à 10 µm, telle qu'inférieure à 5 µm, par exemple de 1 à 2 µm, et l'épaisseur de la première ligne de connexion électrique latérale (109) est de 0,2 à 5 µm, telle que de 0,5 à 1 µm.

14. Procédé selon l'une quelconque des revendications précédentes 12 à 13, dans lequel le procédé comprend la réalisation d'une seconde couche de matériau de liaison (207) sur une surface de la seconde ligne de connexion électrique latérale (210) et la réalisation d'au moins une structure d'étanchéité (219) sur une partie de la première ligne de connexion électrique latérale (209).

15. Procédé selon l'une quelconque des revendications précédentes 12 à 14, dans lequel le procédé comprend la réalisation d'au moins une tranchée (205, 213) dans le premier substrat (202).
